# FASCICULE DE BREVET EUROPEEN

(11) **EP 2 987 168 B1**
(45) Date de publication et mention de la délivrance du brevet: **13.03.2019**
(21) Numéro de dépôt: 14722276.4
(22) Date de dépôt: 15.04.2014
(51) Int. Cl.: G11C 14/00, G11C 11/16, G11C 13/00

(54) **CELLULE MÉMOIRE AVEC MÉMORISATION DE DONNÉES NON VOLATILE**
SPEICHERZELLE MIT NICHTFLÜCHTIGEM DATENSPEICHER
MEMORY CELL WITH NON-VOLATILE DATA STORAGE

(30) Priorité: 15.04.2013 FR 1353398
(43) Date de publication de la demande: 24.02.2016
(73) Titulaire: Commissariat à l'Énergie Atomique et aux Énergies Alternatives, 75015 Paris (FR); Centre National de la Recherche Scientifique, 75794 Paris Cedex 16 (FR)
(72) Inventeur: DI PENDINA, Grégory, F-38130 Echirolles (FR)
(74) Mandataire: Cabinet Beaumont
(86) Numéro de dépôt international: PCT/FR2014/050913
(87) Numéro de publication internationale: WO 2014/170594

(56) Documents cités:
- FR-A1- 2 970 589
- FR-A1- 2 970 590
- US-A1- 2011 122 709
- YOUNGDON JUNG ET AL: "MTJ based non-volatile flip-flop in deep submicron technology", SOC DESIGN CONFERENCE (ISOCC), 2011 INTERNATIONAL, IEEE, 17 novembre 2011 (2011-11-17), pages 424-427, XP032101617, DOI: 10.1109/ISOCC.2011.6138622 ISBN: 978-1-4577-0709-4

## Description

La présente demande de brevet revendique la priorité de la demande de brevet français FR13/53398.

### Domaine

La présente description concerne une cellule mémoire et un procédé de mémorisation non volatile d'une valeur de données dans une cellule mémoire. En particulier, la présente description concerne une cellule mémoire et un procédé comprenant un ou plusieurs éléments résistifs pouvant être programmés par la direction d'un courant.

### Arrière Plan

On a déjà proposé d'utiliser des éléments résistifs programmables dans des cellules mémoires pour assurer une mémorisation de données non volatile. De tels éléments résistifs sont programmables pour prendre l'un d'une pluralité d'états résistifs différents. L'état résistif programmé est conservé même lorsqu'une tension d'alimentation de la cellule mémoire est déconnectée, et par conséquent des données peuvent être mémorisées par de tels éléments de façon non volatile.

Divers types d'éléments résistifs ont été proposés, dont certains peuvent être programmés par la direction d'un courant qu'on fait passer dans les éléments résistifs. Un exemple d'un tel élément résistif programmable par un courant est un élément STT (à couple de transfert de spin), qui est basé sur des jonctions tunnel magnétiques (MTJ).

En raison au moins en partie des transistors utilisés pour programmer les états résistifs, les cellules mémoires basées sur des éléments résistifs programmables ont tendance à être moins compactes que d'autres types de cellules mémoires comme celles de mémoire RAM (mémoire à accès aléatoire) . Il existe un besoin général dans la technique d'une cellule mémoire basée sur des éléments résistifs programmables ayant une surface réduite.

La demande de brevet US publiée sous le numéro US 2011/122709 décrit un circuit logique non-volatil comprenant des cellules mémoire non-volatiles.

La publication par Youngdon Jung et al. ayant comme titre "MTJ based non-volatile flip-flop in deep submicron technology", SOC DESIGN CONFERENCE (ISOCC), 2011 INTERNATIONAL, IEEE, 17 Novembre 2011, pages 424-427, décrit une bascule non-volatile.

### Résumé

Un objet de modes de réalisation de la présente description est de répondre au moins partiellement à un ou plusieurs besoins de l'art antérieur.

Selon un aspect, on prévoit une cellule mémoire comprenant : des premier et deuxième éléments résistifs, au moins l'un d'eux étant programmable pour prendre l'un d'au moins deux états résistifs, une valeur de donnée étant représentée par les résistances relatives des premier et deuxième éléments résistifs, le premier élément résistif étant couplé entre un premier noeud de mémorisation et un premier noeud intermédiaire, le deuxième élément résistif étant couplé entre un deuxième noeud de mémorisation et un deuxième noeud intermédiaire ; un premier transistor couplé entre le premier noeud de mémorisation et une première tension d'alimentation ; un deuxième transistor couplé entre le deuxième noeud de mémorisation et la première tension d'alimentation, un noeud de commande du premier transistor étant couplé au deuxième noeud de mémorisation et un noeud de commande du deuxième transistor étant couplé au premier noeud de mémorisation ; un troisième transistor couplé entre les premier et deuxième noeuds intermédiaires ; un quatrième transistor couplé par ses noeuds de courant principaux entre le premier noeud de mémorisation et un noeud d'entrée de données ; et un circuit de commande agencé, pendant une phase d'écriture, pour activer les troisième et quatrième transistors et pour coupler le noeud d'entrée de données à une deuxième tension d'alimentation par l'intermédiaire d'un premier bloc de circuit pour générer un courant dans une première direction à travers les premier et deuxième éléments résistifs pour programmer l'état résistif d'au moins l'un des éléments.

Selon un mode de réalisation, le premier bloc de circuit comprend au moins un transistor couplé entre le noeud d'entrée de données et la deuxième tension d'alimentation et contrôlé par des données d'entrée de la cellule mémoire.

Selon un mode de réalisation, la cellule mémoire comprend en outre un deuxième bloc de circuit comprenant au moins un transistor couplé entre le noeud d'entrée de données et la première tension d'alimentation et contrôlé par les données d'entrée de la cellule mémoire.

Selon un mode de réalisation, les premier et deuxième blocs de circuit sont agencés pour appliquer à la donnée d'entrée au moins l'une des fonctions logiques du groupe comprenant : une fonction de multiplexage ; une fonction NON ; une fonction NON OU ; une fonction NON ET ; une fonction NON OU EXCLUSIF ; une fonction OU ; une fonction ET ; et une fonction OU EXCLUSIF.

Selon un mode de réalisation, la cellule mémoire comprend en outre un cinquième transistor couplé entre le deuxième noeud de mémorisation et la deuxième tension d'alimentation, le circuit de commande étant en outre agencé, pendant une autre phase d'écriture, pour activer les troisième et cinquième transistors pour générer un courant de programmation dans une deuxième direction dans les premier et deuxième éléments résistifs pour programmer l'état résistif d'au moins l'un des éléments.

Selon un mode de réalisation, la cellule mémoire comprend en outre un sixième transistor couplé entre le deuxième noeud de mémorisation et un autre noeud d'entrée de données, le circuit de commande étant en outre agencé, pendant une autre phase d'écriture, pour activer les troisième et sixième transistors et pour coupler l'autre noeud d'entrée de données à la deuxième tension d'alimentation par l'intermédiaire d'un autre bloc de circuit pour générer un courant de programmation dans une deuxième direction dans les premier et deuxième éléments résistifs pour programmer l'état résistif d'au moins l'un des éléments.

Selon un mode de réalisation, la cellule mémoire comprend en outre un inverseur couplé entre le premier noeud de mémorisation et le deuxième noeud de mémorisation, le circuit de commande étant en outre agencé, pendant une autre phase d'écriture, pour activer les troisième et quatrième transistors et pour coupler le noeud d'entrée de données à la première tension d'alimentation par l'intermédiaire du deuxième bloc de circuit pour générer un courant de programmation dans une deuxième direction dans les premier et deuxième éléments résistifs pour programmer l'état résistif d'au moins l'un des éléments.

Selon un mode de réalisation, chacun des premier et deuxième transistors est connecté à la première tension d'alimentation.

Selon un mode de réalisation, au moins l'un des premier et deuxième éléments résistifs est l'un des éléments suivants : un élément à couple de transfert de spin ayant une anisotropie dans le plan ; un élément à couple de transfert de spin ayant une anisotropie perpendiculaire au plan ; un élément à oxydoréduction (RedOx) ; un élément ferroélectrique ; et un élément à changement de phase.

Selon un mode de réalisation, chacun des premier et deuxième transistors comprend un noeud de substrat, et le circuit de commande est en outre agencé pour coupler le noeud de substrat d'au moins l'un des premier et deuxième transistors à une troisième tension d'alimentation différente de la première tension d'alimentation pendant que le noeud d'entrée de données est couplé à la deuxième tension d'alimentation.

Selon un mode de réalisation, la cellule mémoire comprend en outre un septième transistor couplé entre le premier noeud intermédiaire et la deuxième tension d'alimentation ; et un huitième transistor couplé entre le deuxième noeud intermédiaire et la deuxième tension d'alimentation, les septième et huitième transistors étant par exemple adaptés à avoir une tension de seuil inférieure à celle des premier et deuxième transistors.

Selon un autre aspect, on prévoit un dispositif mémoire comprenant : un réseau des cellules mémoires susmentionnées, les noeuds d'entrée de données des cellules mémoires étant couplés à des premières lignes de bits du dispositif mémoire.

Selon un autre aspect, on prévoit un dispositif mémoire synchrone comprenant la cellule mémoire susmentionnée et une autre cellule mémoire couplée en série avec la cellule mémoire, l'autre cellule mémoire comprenant deux inverseurs couplés de façon croisée.

Selon un autre aspect, on prévoit un procédé de mémorisation non volatile d'une valeur de donnée dans une cellule mémoire, la cellule mémoire comprenant des premier et deuxième éléments résistifs, dont au moins l'un est programmable pour prendre l'un d'au moins deux états résistifs, une valeur de donnée étant représentée par les résistances relatives des premier et deuxième éléments résistifs, le premier élément résistif étant couplé entre un premier noeud de mémorisation et un premier noeud intermédiaire, le deuxième élément résistif étant couplé entre un deuxième noeud de mémorisation et un deuxième noeud intermédiaire ; un premier transistor couplé entre le premier noeud de mémorisation et une première tension d'alimentation ; un deuxième transistor couplé entre le deuxième noeud de mémorisation et la première tension d'alimentation, un noeud de commande du premier transistor étant couplé au deuxième noeud de mémorisation et un noeud de commande du deuxième transistor étant couplé au premier noeud de mémorisation ; un troisième transistor couplé entre les premier et deuxième noeuds intermédiaires ; un quatrième transistor couplé par ses noeuds de courant principaux entre le premier noeud de mémorisation et un noeud d'entrée de données, le procédé comprenant : activer les troisième et quatrième transistors ; coupler le noeud d'entrée de données à une deuxième tension d'alimentation par l'intermédiaire d'un premier bloc de circuit d'entrée pendant que les troisième et quatrième transistors sont activés pour générer un courant de programmation dans une première direction dans les premier et deuxième éléments résistifs pour programmer l'état résistif d'au moins l'un des éléments.

### Brève description des dessins

Les caractéristiques et avantages susmentionnés, et d'autres, apparaîtront clairement avec la description détaillée suivante de modes de réalisation, faite à titre d'illustration et non de limitation, en référence aux dessins joints, dans lesquels :
la figure 1 illustre schématiquement une cellule mémoire qui a été proposée ;
la figure 2 illustre schématiquement une cellule mémoire selon un exemple de réalisation de la présente description ne tombant pas sous la protection des revendications jointes en annexe;
les figures 3A et 3B sont des chronogrammes représentant des signaux dans le circuit de la figure 2 pendant une phase de transfert de données selon un exemple de réalisation de la présente description ;
les figures 4A et 4B sont des chronogrammes représentant des signaux dans le circuit de la figure 2 pendant une phase d'écriture selon un exemple de réalisation de la présente description ;
la figure 5 illustre schématiquement une cellule mémoire selon un autre exemple de réalisation de la présente description ;
les figures 6A et 6B sont des chronogrammes représentant des signaux dans la cellule mémoire de la figure 5 pendant une phase d'écriture selon un exemple de réalisation de la présente description ;
les figures 7A et 7B illustrent schématiquement plus en détail des circuits de la cellule mémoire de la figure 5 selon des exemples de réalisation de la présente description ;
la figure 8 illustre schématiquement une cellule mémoire selon un autre exemple de réalisation de la présente description ;
la figure 9 illustre schématiquement une cellule mémoire selon encore un autre exemple de réalisation de la présente description ;
la figure 10 illustre schématiquement un dispositif mémoire synchrone selon un exemple de réalisation de la présente description ;
la figure 11 illustre schématiquement un réseau mémoire selon un exemple de réalisation de la présente description ; et
les figures 12A et 12B illustrent des éléments résistifs basés sur des jonctions tunnel magnétiques selon des exemples de réalisation de la présente description.

### Description détaillée

Dans la description suivante, le terme "connecté" est utilisé pour désigner une connexion directe entre un élément et un autre, tandis que le terme "couplé" implique que la connexion entre les deux éléments peut être faite directement, ou via un élément intermédiaire, comme un transistor, une résistance ou un autre composant.

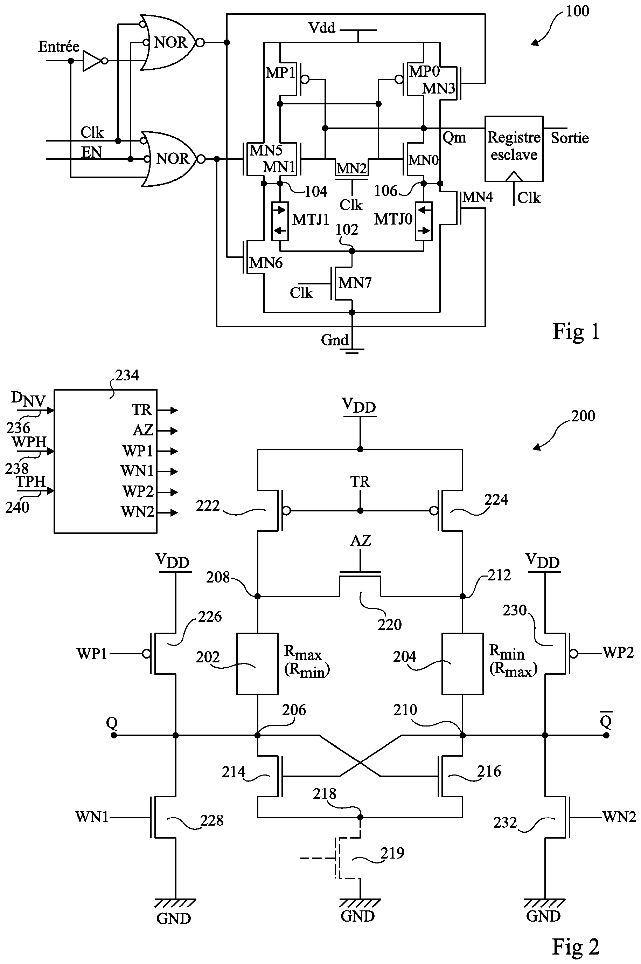

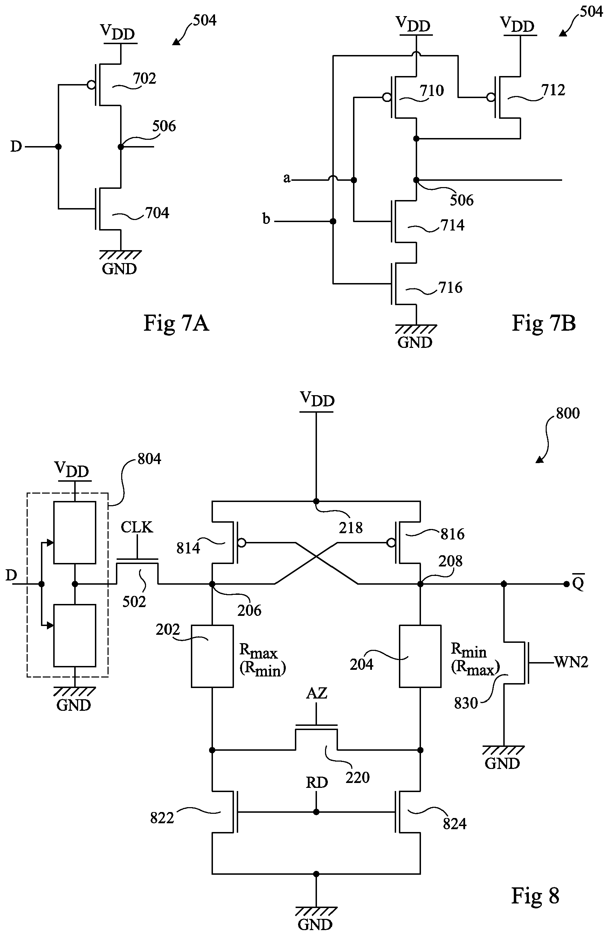

La figure 1 reproduit sensiblement la figure 7 de la publication intitulée "Spin-MTJ based Non volatile Flip-Flop", Weisheng Zhao et al., Proceedings of the 7th IEEE International Conférence on Nanotechnology August 2-5, 2007, Hong-Kong.

La bascule 100 représentée en figure 1 comprend un registre maître et un registre esclave. Le registre maître comprend des dispositifs à jonction tunnel magnétique MTJ1 et MTJO, programmables par un courant. Le dispositif MTJ1 est connecté entre un noeud intermédiaire 104 et un noeud d'interconnexion 102. Le dispositif MTJ0 est connecté entre un noeud intermédiaire 106 et le noeud d'interconnexion 102. Le noeud d'interconnexion 102 connecte entre eux les dispositifs MTJ MTJ0 et MTJ1. Le noeud intermédiaire 104 est en outre couplé à une tension d'alimentation Vdd par l'intermédiaire de deux transistors MN1 et MP1 couplés en série et formant un premier inverseur. Le noeud intermédiaire 106 est en outre couplé à la tension d'alimentation Vdd par l'intermédiaire de deux transistors MP0 et MN0 couplés en série et formant un deuxième inverseur. Les premier et deuxième inverseurs sont couplés de façon croisée entre eux, et la sortie du deuxième inverseur est connectée au registre esclave. Un transistor MN2 est couplé entre les noeuds de grille des transistors MN1 et MN0.

Un transistor MN5 est couplé entre le noeud intermédiaire 104 et la tension d'alimentation Vdd, et un transistor MN6 est couplé entre le noeud intermédiaire 104 et la masse. En outre, un transistor MN3 est couplé entre le noeud intermédiaire 106 et la tension d'alimentation Vdd, et un transistor MN4 est couplé entre le noeud intermédiaire 106 et la masse. Un transistor MN7 est couplé entre le noeud intermédiaire 102 et la masse. Les transistors MN3 à MN6 permettent le passage d'un courant dans les éléments résistifs MTJ1 et MTJ0 dans une direction ou dans l'autre afin de programmer les états résistifs des dispositifs MTJ. Pendant cette phase de programmation, le transistor MN7 est utilisé pour déconnecter le noeud 102 de la masse.

Une paire de portes NOR et un inverseur sur le côté gauche de la figure 1, qui sont contrôlés par un signal d'entrée, un signal d'horloge Clk et un signal d'activation EN, génèrent des signaux pour contrôler les transistors MN3 à MN6.

Un inconvénient du circuit de la figure 1 est que le registre maître comprend un total de 10 transistors, sans tenir compte de ceux des portes NOR et de l'inverseur.

La figure 2 illustre une cellule mémoire 200 selon un exemple de réalisation de la présente description ne tombant pas sous la protection des revendications jointes en annexe.

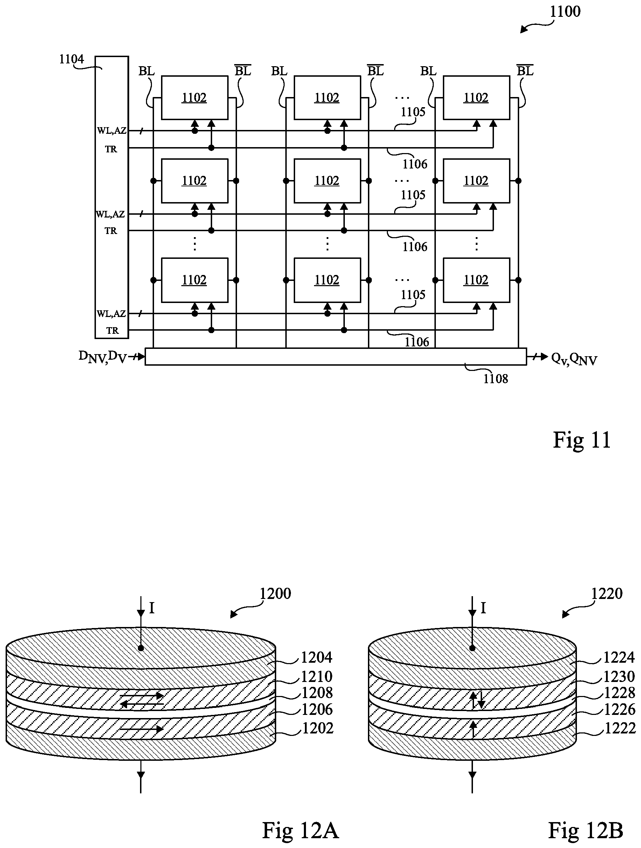

La cellule mémoire 200 comprend des éléments résistifs 202 et 204, chacun d'eux pouvant être programmé pour prendre l'un d'une pluralité d'états résistifs. Les éléments résistifs 202 et 204 peuvent être d'un type quelconque d'élément à commutation de résistance pour lequel la résistance est programmable par la direction d'un courant qu'on fait passer dedans. Par exemple, comme on va le décrire plus en détail dans la suite en référence aux figures 12A et 12B, les éléments à commutation de résistance 202, 204 sont des éléments à couple de transfert de spin ayant une anisotropie dans le plan ou perpendiculaire au plan, comme cela est décrit plus en détail dans la publication intitulée "Magnonic spin-transfer torque MRAM with low power, high speed, and error-free switching", N. Mojumder et al., IEDM Tech. Digest (2010), et dans la publication intitulée "Electric toggling of magnets", E. Tsymbal, Natural Materials Vol 11, January 2012. À titre de variante, les éléments résistifs pourraient être ceux utilisés dans des mémoires à commutation de résistance RAM de type RedOx (RAM à oxydoréduction), qui sont par exemple décrites plus en détail dans la publication intitulée "Redox-Based Resistive Switching Memories - Nanoionic Mechanisms, Prospects and Challenges", Rainer Waser et al., Advanced Materials 2009, 21, pages 2632 à 2663. Dans encore un autre exemple, les éléments résistifs pourraient être ceux utilisés dans des mémoires de type FeRAM (RAM ferroélectriques) ou des PCRAM (RAM à changement de phase).

Quel que soit le type d'élément résistif, un bit de donnée est par exemple mémorisé dans la cellule mémoire de façon non volatile en mettant l'un des éléments à une résistance relativement élevée (Rₘₐₓ), et l'autre à une résistance relativement basse (Rₘᵢₙ). Dans l'exemple de la figure 2, l'élément 202 est programmé pour avoir une résistance Rₘₐₓ et l'élément 204 une résistance Rₘᵢₙ représentant une valeur du bit de donnée, et comme cela est représenté par les références Rₘᵢₙ et Rₘₐₓ entre parenthèses, une programmation opposée des valeurs de résistance mémorise la valeur opposée du bit de donnée. Chacun des éléments à commutation de résistance 202, 204 a par exemple seulement deux états résistifs correspondant aux résistances haute et basse Rₘₐₓ et Rₘᵢₙ, mais les valeurs exactes de Rₘᵢₙ et Rₘₐₓ peuvent varier en fonction de conditions telles que le procédé, les matériaux, les variations de température, etc.

Le bit de donnée non volatile représenté par les éléments résistifs 202, 204 dépend duquel des éléments résistifs a la résistance Rₘₐₓ ou Rₘᵢₙ, en d'autres termes, dépend des résistances relatives. Les éléments résistifs 202, 204 sont par exemple sélectionnés de telle sorte que Rₘₐₓ soit toujours notablement supérieure à Rₘᵢₙ, par exemple supérieure d'au moins 20 pourcent. En général, le rapport entre la résistance Rₘₐₓ et la résistance Rₘᵢₙ est par exemple compris entre 1,2 et 10000. Rₘᵢₙ est par exemple dans la région des 2 kilo-ohms ou moins, et Rₘₐₓ est par exemple dans la région des 6 kilo-ohms ou plus, bien que d'autres valeurs soient possibles.

Il sera clair pour l'homme de l'art que dans certains modes de réalisation, plutôt que les deux éléments résistifs 202, 204 soient programmables, un seul soit programmable. Dans un tel cas, l'autre élément résistif a par exemple une résistance fixe à un niveau intermédiaire environ à mi-chemin entre Rₘᵢₙ et Rₘₐₓ, par exemple égal avec une tolérance de 10 pourcent, à (Rₘᵢₙ+(Rₘₐₓ-Rₘᵢₙ)/2). Par exemple, l'un des éléments résistifs 202, 204 pourrait correspondre à une résistance de valeur fixe. A titre de variante, l'un des éléments résistifs 202, 204 pourrait être constitué de deux éléments résistifs programmables couplés en parallèle et ayant des orientations opposées, de sorte quel que soit le sens dans lequel chaque élément est programmé, la valeur de résistance reste relativement constante au niveau intermédiaire.

L'élément résistif 202 est couplé entre un noeud de mémorisation 206 et un noeud intermédiaire 208. L'élément résistif 204 est couplé entre un noeud de mémorisation 210 et un noeud intermédiaire 212. Les noeuds de mémorisation 206 et 210 mémorisent des tensions Q et *Q̅* respectivement. Deux inverseurs sont couplés de façon croisée entre les noeuds de mémorisation 206 et 210 pour former un registre. Chaque inverseur est constitué d'un seul transistor 214, 216 respectivement. Le transistor 214 est par exemple un transistor MOS à canal N (NMOS) couplé par ses noeuds de courant principaux entre le noeud 206 et un autre noeud 218. Le transistor 216 est par exemple un transistor NMOS couplé par ses noeuds de courant principaux entre le noeud de mémorisation 210 et l'autre noeud 218. Un noeud de commande du transistor 214 est couplé au noeud de mémorisation 210, et un noeud de commande du transistor 216 est couplé au noeud de mémorisation 206. Le noeud 218 est soit connecté à la masse, soit couplé à la masse par l'intermédiaire des noeuds de courant principaux d'un transistor NMOS 219, représenté par des lignes en pointillés en figure 2.

Les noeuds intermédiaires 208 et 212 sont couplés entre eux par l'intermédiaire des noeuds de courant principaux d'un transistor NMOS 220. Le transistor 220 reçoit sur son noeud de commande un signal AZ décrit plus en détail ci-après.

Le noeud 208 est en outre couplé à une tension d'alimentation V_{DD} par l'intermédiaire des noeuds de courant principaux d'un transistor MOS à canal P (PMOS) 222. De façon similaire, le noeud 212 est couplé à la tension d'alimentation V_{DD} par l'intermédiaire des noeuds de courant principaux d'un transistor PMOS 224. Les noeuds de commande des transistors PMOS 222 et 224 sont couplés ensemble à un signal de transfert TR décrit plus en détail ci-après.

Le noeud de mémorisation 206 est en outre couplé à la tension d'alimentation V_{DD} par l'intermédiaire des noeuds de courant principaux d'un transistor PMOS 226, et à la masse par l'intermédiaire des noeuds de courant principaux d'un transistor NMOS 228. Les transistors 226 et 228 reçoivent sur leurs noeuds de commande des signaux d'écriture WP1 et WN1 respectivement. De façon similaire, le noeud de mémorisation 210 est couplé à la tension d'alimentation V_{DD} par l'intermédiaire des noeuds de courant principaux d'un transistor PMOS 230, et à la masse par l'intermédiaire des noeuds de courant principaux d'un transistor NMOS 232. Les transistors 230 et 232 reçoivent sur leurs noeuds de commande des signaux d'écriture WP2 et WN2 respectivement.

La figure 2 illustre aussi un bloc de commande 234, fournissant les signaux de commande TR, AZ, WP1, MN1, WP2 et WN2 allant vers les transistors correspondants de la cellule mémoire 200. Comme cela est illustré, ces signaux de commande sont par exemple générés sur la base de données non volatiles D_{NV} reçues sur une ligne d'entrée 236, d'un signal de phase d'écriture WPH reçu sur une ligne d'entrée 238, et d'un signal de phase de transfert TPH reçu sur une ligne d'entrée 240.

Dans la bascule 100 de la figure 1, les transistors MP1 et MP0 sont couplés au rail d'alimentation Vdd et ont pour rôle de maintenir un état haut sur l'un des noeuds du registre formé par les quatre transistors MN0, MN1, MP0 et MP1. Dans la cellule 200 de la figure 2, dans laquelle chaque inverseur est mis en oeuvre par un seul transistor 214, 216, l'état haut de Q ou *Q̅* est maintenu par un courant de fuite passant dans les transistors PMOS 222 ou 224, et/ou dans les transistors PMOS 226 et 230.

Les tensions de seuil des transistors PMOS 222, 224 et/ou 226, 230 sont choisies de façon à être inférieures à celles des transistors NMOS 214, 216, 228, 232 de sorte que lorsqu'ils sont dans l'état non conducteur, le courant de fuite dans les transistors 222, 224 et/ou 226, 230 est supérieur à celui dans les transistors 214, 216, 228, 232, maintenant ainsi le noeud correspondant 206 ou 210 à une tension suffisamment haute pour être vue comme un état logique haut. En d'autres termes, le courant de fuite I_{offP} passant dans le transistor PMOS 222, 224 et/ou 226, 230 lorsqu'une tension de niveau haut est appliquée aux noeuds de grille correspondants est supérieur au courant de fuite I_{offN} passant dans le transistor NMOS correspondant 214, 216, 228 ou 232 lorsqu'une tension de niveau bas est appliquée sur son noeud de grille.

Les tensions de seuil particulières vont dépendre de la technologie utilisée. À titre d'exemple, les tensions de seuil des transistors PMOS 222, 224, et/ou 226, 230 sont choisies de façon à être dans la plage de 0,3 à 0,5 V, alors que les tensions de seuil des transistors NMOS 214, 216, 228, 232 sont la plage de 0,4 à 0,6 V. Dans tous les cas, le rapport I_{0ffp}/I_{Offn} est sélectionné par exemple pour être supérieur à 25, et de préférence supérieur à 100.

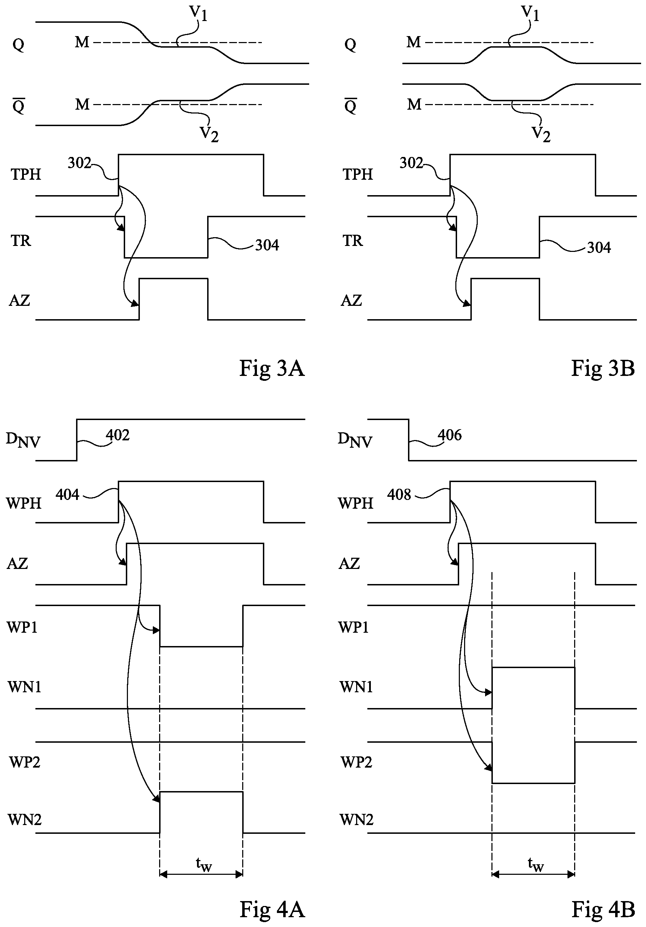

On va maintenant décrire plus en détail le fonctionnement du circuit de la figure 2 en faisant référence aux figures 3A et 3B, et 4A et 4B.

D'abord, on notera que, contrairement à la bascule de la figure 1, la cellule mémoire 200 est capable de mémoriser, de façon volatile, un bit de donnée qui est indépendant des états résistifs programmés des éléments 202 et 204. En effet, le registre formé par les transistors 214 et 216 va conserver tout état mémorisé.

Les figures 3A et 3B sont des chronogrammes représentant des signaux dans la cellule mémoire de la figure 2 pendant une phase de transfert. En particulier, les figures 3A et 3B illustrent les signaux de données Q et *Q̅* présents sur les noeuds de mémorisation 206 et 210, le signal de phase de transfert TPH, le signal de transfert TR, et le signal AZ pendant une phase de transfert du circuit.

La phase de transfert correspond à une opération consistant à transférer la donnée représentée par les états résistifs programmés des éléments résistifs 202 et 204 vers les noeuds de mémorisation 206, 210. Ainsi, la donnée est transformée d'une représentation par l'état résistif programmé en une représentation par des niveaux de tension sur les noeuds de mémorisation 206 et 210.

Ainsi, la phase de transfert implique d'établir les niveaux des tensions Q et *Q̅* sur les noeuds de mémorisation 206 et 210 sur la base des états résistifs programmés. Dans les exemples des figures 3A et 3B, on suppose que l'élément résistif 202 a été programmé de façon à avoir une résistance élevée Rₘₐₓ, et l'élément résistif 204 une résistance basse Rₘᵢₙ. Bien que cela ne soit pas représenté dans les figures 3A et 3B, pendant la phase de transfert, les signaux de commande WP1, WP2 sont hauts et les signaux de commande WN1, WN2 sont bas de telle sorte que les transistors correspondants 226 à 232 sont tous non conducteurs.

La figure 3A correspond à un cas dans lequel les tensions Q et *Q* sont initialement à un état haut et à un état bas respectivement. Le terme "état haut" est utilisé ici pour désigner un niveau de tension proche ou égal au niveau de la tension d'alimentation V_{DD}, tandis que le terme "état bas" est utilisé ici pour désigner un niveau de tension proche ou égal à la tension de masse.

Le signal de transfert TR est par exemple initialement haut, de sorte que les transistors 222 et 224 sont non-conducteurs. Le signal AZ est par exemple initialement bas, de sorte que le transistor 220 est non conducteur.

Le signal de phase de transfert TPH, qui est par exemple initialement bas, est activé comme cela est représenté par un front montant 302, déclenchant peu de temps après un front descendant du signal de transfert TR, et un front montant du signal AZ, par exemple peu de temps après le front descendant du signal de transfert TR. Ainsi, les transistors 220, 222 et 224 de la figure 2 sont tous activés, induisant un courant dans la branche de gauche de la cellule mémoire 200 qui passe dans le transistor 222, dans l'élément résistif 202 et le transistor 214, et un courant dans la branche de droite de la cellule mémoire qui passe dans le transistor 224, dans l'élément résistif 204 et le transistor 216.

Toutefois, en raison de la différence entre les résistances des éléments résistifs 202 et 204, le courant dans la branche de gauche est inférieur au courant dans la branche de droite. Ainsi, ces courants par exemple provoquent la descente de la tension sur le noeud de mémorisation 206 et son établissement à un niveau V₁ inférieur à un niveau de métastabilité M, et la montée de la tension sur le noeud de mémorisation 210 jusqu'à un niveau V₂ supérieur au niveau de métastabilité M. Le niveau de métastabilité M est un niveau de tension théorique situé environ à mi-chemin entre les états de tension haut et bas, représentant le niveau à partir duquel il y aurait une probabilité égale que Q bascule vers l'état haut ou vers l'état bas. L'activation du signal AZ pour rendre conducteur le transistor 220 a pour effet d'accélérer la descente du niveau de tension Q, et la montée du niveau de tension *Q̅* .

Le signal AZ est ensuite amené à l'état bas, et le signal de transfert TR est amené de nouveau à l'état haut sur un front montant 304, de sorte que les niveaux Q et *Q̅* vont vers leur état stable le plus proche, qui dans l'exemple de la figure 3A correspond à l'état Q bas, *Q̅* haut. Toutefois, il sera clair pour l'homme de l'art que les niveaux V₁ et V₂, et l'état stable final, vont dépendre de facteurs tels que la résistance à l'état conducteur des transistors 214, 216, 222 et 224. Finalement, le signal de phase de transfert TPH, passe à l'état bas pour achever la phase de transfert.

La figure 3B correspond à un cas dans lequel les tensions Q et *Q̅* sont initialement à un état bas et un état haut respectivement. Le signal de phase de transfert TPH, le signal de transfert TR et le signal AZ ont les mêmes formes que celles de la figure 3A et ne vont pas être décrits de nouveau. La différence par rapport à la figure 3A est que, lorsque le signal TR est amené à l'état bas et le signal AZ est amené à l'état haut, la tension Q monte vers le niveau V₁, et la tension *Q̅* descend vers le niveau V₂. Après cela, les niveaux Q et *Q̅* vont vers leur état stable le plus proche, qui dans l'exemple de la figure 3B correspond à l'état Q bas et *Q̅* haut. Toutefois, ici encore il sera clair pour l'homme de l'art que les niveaux V₁ et V₂, et l'état stable final, vont dépendre de facteurs tels que les résistances à l'état conducteur des transistors 214, 216, 222 et 224.

Les figures 4A et 4B sont des chronogrammes illustrant des exemples des signaux D_{NV}, WPH, AZ, WP1, WN1, WP2 et WN2 dans le circuit de la figure 2 pendant une phase d'écriture des états résistifs des éléments résistifs 202 et 204. Bien que cela ne soit pas représenté dans les figures 4A et 4B, pendant la phase d'écriture, le signal de transfert TR par exemple reste haut de sorte que les transistors 222 et 224 sont non conducteurs.

La phase d'écriture implique le passage d'un courant dans chacun des éléments résistifs 202, 204 par l'intermédiaire du transistor 220, soit dans la direction allant du noeud de mémorisation 206 vers le noeud de mémorisation 210, soit dans la direction opposée. Les éléments résistifs 202 et 204 sont orientés de telle sorte que, pour une direction donnée du courant, ils vont être programmés de façon à avoir des résistances opposées. En particulier, chaque élément résistif 202, 204 peut être orienté dans l'une de deux façons entre le noeud de mémorisation 206, 210 correspondant et le noeud intermédiaire 208, 212 correspondant. Dans le cas d'un élément STT, l'orientation est déterminée par l'ordre d'une couche fixe et d'une couche de mémorisation, comme cela va être décrit plus en détail ci-après. Les éléments 202, 204 sont tous deux par exemple orientés de la même façon entre ces noeuds correspondants, par exemple chacun ayant sa couche fixe située la plus proche du noeud de mémorisation 206, 210 correspondant, de sorte qu'ils ont des orientations opposées par rapport à un courant d'écriture passant du noeud de mémorisation 206 vers le noeud de mémorisation 210 ou vice versa.

Comme cela est illustré en figure 4A, initialement les signaux AZ, WN1 et WN2 sont bas, et les signaux WP1 et WP2 sont haut, de sorte que les transistors 220 et 226 à 232 sont tous non conducteurs.

Le signal de données D_{NV} sur la ligne d'entrée 236 du circuit de commande 234 est par exemple d'abord mis à la valeur qui doit être programmée dans la cellule mémoire. Dans l'exemple de la figure 4A, la valeur est l'état logique "1" et le signal de données D_{NV} par exemple commence bas, et passe à une valeur haute sur un front montant 402.

Le signal de phase d'écriture WPH sur la ligne d'entrée 238 du circuit de commande 234 passe ensuite à l'état haut sur un front montant 404, lançant le début de la phase d'écriture. Cela déclenche, peu de temps après, un front montant du signal AZ, de sorte que le transistor 220 est activé, couplant entre eux les noeuds 208 et 212. En outre, peu de temps après, les signaux WP1, WN1, WP2 et WN2 sont mis à des valeurs appropriées pour provoquer le passage d'un courant dans les éléments résistifs 202 et 204 dans une direction qui va programmer leurs résistances conformément à la valeur de donnée "1" logique qui doit être programmée. Dans l'exemple de la figure 2, un état haut d'une valeur de donnée D_{NV} correspond à une valeur haute de la tension Q, en d'autres termes à une résistance Rₘᵢₙ de l'élément 202, et une résistance Rₘₐₓ de l'élément 204. Cela est par exemple obtenu en faisant passer un courant à partir du noeud de mémorisation 206, à travers les éléments résistifs 202 et 204, vers le noeud de mémorisation 210. Comme cela est représenté en figure 4A, cette direction de courant est générée en amenant le signal WP1 à l'état bas pour activer le transistor 226, et en amenant le signal WN2 à l'état haut pour activer le transistor 232.

Après que le courant a été appliqué pendant un temps suffisant pour établir les états résistifs des éléments 202 et 204, par exemple pendant une durée t_{W} comprise entre 0,1 ns et 20 ns, le signal WP1 est amené de nouveau à l'état haut, et le signal WN2 est amené à l'état bas, arrêtant le courant d'écriture. Les signaux AZ et WPH sont ensuite par exemple amenés à l'état bas, ce qui termine la phase d'écriture.

La figure 4B illustre un cas alternatif d'une phase d'écriture dans lequel la valeur de donnée à programmer est un état logigue "0", et ainsi le signal de donnée D_{NV} a un front descendant 406. Un front montant 408 du signal d'écriture déclenche ainsi un front montant du signal WN1 et un front descendant du signal WP2, afin de générer un courant à partir du noeud de mémorisation 210, à travers les éléments résistifs 204 et 202, vers le noeud de mémorisation 206, pendant une durée t_{W}. Cela programme une résistance Rₘᵢₙ de l'élément 202, et une résistance Rₘₐₓ de l'élément 204.

Les transistors 220 et 226 à 232 sont par exemple dimensionnés de telle sorte que le courant d'écriture généré par l'activation des transistors 226, 220 et 232, ou par l'activation des transistors 230, 220 et 228, soit suffisamment élevé pour programmer les états résistifs des éléments 202 et 204. En fonction du type et des dimensions des éléments résistifs 202, 204, un tel courant de programmation minimum serait par exemple de l'ordre de 20 µA à 1,5 mA. Au contraire, les transistors 214, 216 et 222, 224 sont par exemple dimensionnés de telle sorte que, pendant une phase de transfert lorsque le signal de transfert TR est activé, le niveau du courant passant dans les éléments résistifs 202 et 204 soit inférieur à celui nécessaire pour programmer leurs états résistifs, par exemple un niveau inférieur de 10 à 90 pourcent par rapport au courant d'écriture correspondant.

En référence à la figure 1 décrite précédemment, pendant une phase d'écriture des dispositifs MTJ, le transistor MN7 est nécessaire afin de déconnecter le noeud 102 de la masse, et ainsi éviter que le courant d'écriture ne s'écoule vers la masse. Toutefois, comme cela a été décrit précédemment, le transistor 219 entre le noeud 218 et la masse dans la cellule mémoire 200 peut être supprimé. En effet, puisque les transistors 214 et 216 formant un registre sont situés entre les noeuds de mémorisation 206, 210 et la masse, le courant d'écriture va encore s'écouler à travers les éléments résistifs même si le noeud 218 est couplé à la masse pendant la phase d'écriture.

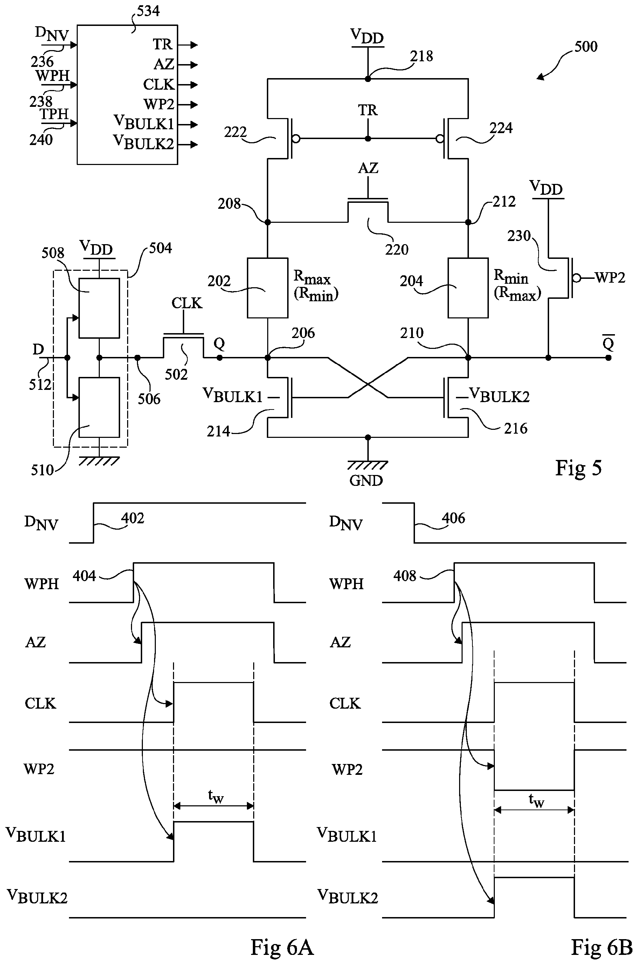

La figure 5 illustre une cellule mémoire 500 selon une variante de réalisation par rapport à celle de la figure 2. De nombreux éléments de la cellule mémoire 500 sont identiques à ceux de la cellule mémoire 200, et ces éléments portent les mêmes références numériques et ne seront pas décrits de nouveau en détail.

Une différence dans la cellule mémoire 500 est que les transistors 226, 228 et 232 ont été supprimés, laissant seulement un unique transistor 230 dédié à la génération du courant d'écriture. Un transistor NMOS supplémentaire 502 est couplé par ses noeuds de courant principaux entre le noeud de mémorisation 206 et un circuit d'entrée 504. En particulier, le transistor 502 est couplé à un noeud d'entrée de données 506 de la cellule mémoire. Le noeud 506 est couplé à la tension d'alimentation V_{DD} par l'intermédiaire d'un bloc de circuit 508 du circuit d'entrée 504, et à la masse par l'intermédiaire d'un bloc de circuit 510 du circuit d'entrée 504. Le transistor 502 est par exemple contrôlé par un signal d'horloge CLK. Les blocs de circuit 508 et 510 sont contrôlés par des données d'entrée D au niveau d'une entrée 512. Comme cela apparaîtra clairement d'après la description qui suit, les données d'entrée D peuvent comprendre un unique signal de données ou plusieurs signaux de données pour contrôler les blocs de circuits 508, 510.

En outre, des noeuds de tension de substrat des transistors 214 et 216 sont illustrés en figure 5. Le circuit de commande 234 est aussi remplacé dans la cellule mémoire 500 par un circuit de commande 534, qui ne fournit plus les signaux de commande WN1, WP1 et WN2, et fournit optionnellement des niveaux de tension de substrat V_{BULK1} et V_{BULK2}, qui sont appliqués au noeud de tension de substrat des transistors 214 et 216 respectivement, comme on va le décrire plus en détail ci-après.

Une phase de transfert peut être mise en oeuvre dans le circuit 500 de la même façon que cela a été décrit précédemment en relation avec les figures 3A et 3B, et ne va pas être décrite de nouveau en détail. Pendant une telle phase de transfert, le transistor 502 est par exemple désactivé par un état bas du signal d'horloge CLK, de sorte que le noeud de mémorisation 206 est isolé du circuit d'entrée 504.

Une phase d'écriture des éléments résistifs 202 et 204 est mise en oeuvre en utilisant le transistor PMOS 230 ou le circuit d'entrée 504, en fonction de la direction du courant d'écriture à appliquer. En particulier, le circuit d'entrée 504 correspond à un dispositif de type CMOS typique comprenant, dans le bloc de circuit 508, un ou plusieurs transistors PMOS couplés à la tension d'alimentation V_{DD}, et, dans le bloc de circuit 510, un ou plusieurs transistors NMOS, couplés à la masse. Par exemple, le circuit d'entrée 504 correspond à un inverseur, un multiplexeur, une porte NON OU, une porte NON ET, ou un autre circuit logique.

Afin de programmer les éléments résistifs 202, 204 avec un courant d'écriture circulant à partir du noeud de mémorisation 206 vers le noeud de mémorisation 210, le transistor 502 est activé, et le bloc de circuit 508 est aussi activé par une valeur appropriée du signal de données D pour coupler le noeud intermédiaire 506 à la tension d'alimentation V_{DD}. Le chemin entre le noeud de mémorisation 210 et la masse est par exemple assuré par le transistor 216.

Afin de programmer les éléments résistifs 202, 204 avec un courant d'écriture passant du noeud de mémorisation 210 vers le noeud de mémorisation 206, le transistor 230 est activé. Le chemin entre le noeud de mémorisation 206 et la masse est soit assuré uniquement par le transistor 214, soit par le transistor 214 et en plus par l'activation du transistor 502 et du bloc de circuit 510 par une donnée d'entrée D appropriée sur l'entrée 512.

Le circuit d'entrée 504, en plus de fournir un état de tension au noeud d'entrée de données 506 de la cellule mémoire pendant une phase d'écriture, sert aussi par exemple comme interface d'entrée ou de sortie de la cellule mémoire 500. En particulier, le circuit d'entrée 504 par exemple applique un signal au noeud d'entrée de données 506 pour programmer les états de tension Q et *Q̅* sur les noeuds de mémorisation 206 et 210 pendant que la cellule mémoire fonctionne comme une bascule à verrouillage standard. Ainsi, la donnée d'entrée D établit par exemple la valeur de donnée à programmer au niveau des noeuds de mémorisation 206, 210 de façon volatile. Pendant une phase d'écriture des éléments de programmation 202, 204, cette même valeur de données est par exemple utilisée pour programmer les états résistifs des éléments 202, 204 pour mémoriser la valeur de données de manière non volatile.

En plus ou à la place, le circuit d'entrée 504 peut être agencé pour lire l'état de tension Q sur le noeud de mémorisation 206, et le circuit d'entrée 504 par exemple fonctionne en plus comme circuit de sortie de la cellule mémoire 500.

Avantageusement, en utilisant le circuit d'entrée 504 et le transistor 502 pour appliquer un niveau de tension au noeud de mémorisation 206 ou 210 pendant une phase d'écriture des éléments résistifs 202, 204, le reste de la cellule mémoire 500 de la figure 5 peut comprendre seulement six transistors. Bien sûr, dans des variantes de réalisation, la cellule mémoire 500 de la figure 5 pourrait en outre comprendre les transistors 228, 232 et/ou 219 du mode de réalisation de la figure 2.

On va maintenant décrire plus en détail le fonctionnement de la cellule mémoire 500 pendant une phase d'écriture, en référence aux figures 6A et 6B.

Les figures 6A et 6B illustrent des exemples de chronogrammes des signaux D_{NV}, WPH, AZ, CLK, WP2, B_{BULK1} et V_{BULK2} dans le circuit de la figure 5 pendant une phase d'écriture des états résistifs des éléments résistifs 202 et 204. Les signaux D_{NV}, WPH, AZ et WP2 sont les mêmes que ceux des figures 4A et 4B, et ne vont pas être décrits de nouveau en détail.

Dans l'exemple de la figure 6A, le courant d'écriture est généré en activant seulement les transistors 502 et 220, et en appliquant une donnée d'entrée D appropriée pour coupler le noeud 506 à la tension d'alimentation V_{DD}. Le courant d'écriture circule ainsi à partir du noeud de mémorisation 206, à travers les éléments résistifs 202 et 204, vers le noeud de mémorisation 210. Le noeud 206 étant à une tension relativement élevée, le transistor 216 est conducteur, et ainsi le courant d'écriture passe vers la masse par l'intermédiaire du transistor 216.

Dans l'exemple de la figure 6B, le courant d'écriture est généré en activant les transistors 220 et 230, et optionnellement le transistor 502 en supposant que le noeud 506 est couplé à la masse par l'intermédiaire du bloc de circuit 510. Le courant d'écriture circule ainsi à partir du noeud de mémorisation 210, à travers les éléments résistifs 204 et 202, vers le noeud de mémorisation 206. Le noeud 210 étant à une tension relativement élevée, le transistor 214 est conducteur, et ainsi le courant d'écriture passe vers la masse par l'intermédiaire du transistor 214, et optionnellement aussi par l'intermédiaire du bloc de circuit 510.

La commande des tensions de substrat V_{BULK1} et V_{BULK2} des transistors 214 et 216 peut être utilisée pour augmenter le courant d'écriture, comme on va le décrire maintenant.

En faisant de nouveau référence aux figures 6A et 6B, les tensions de substrat V_{BULK1} et V_{BULK2} appliquées aux transistors 214 et 216 respectivement sont par exemple à la masse, excepté pendant la phase d'écriture. Pendant la phase d'écriture, la tension de substrat de l'un des transistors est commutée sur un niveau de tension supérieur à la masse, par exemple à la tension d'alimentation V_{DD}, au moins pendant la période d'écriture t_{W}.

Dans l'exemple de la figure 6A, le courant d'écriture circule à partir du noeud de mémorisation 206 vers le noeud de mémorisation 210. Par conséquent, la tension de substrat V_{BULK1} du transistor 214 est augmentée pour réduire le courant de fuite passant vers la masse par l'intermédiaire du transistor 214. La tension de substrat V_{BULK2} du transistor 216 reste toutefois basse, de sorte que le transistor 216 reste complètement conducteur.

Dans l'exemple de la figure 6B, le courant d'écriture passe du noeud de mémorisation 210 vers le noeud de mémorisation 206. Par conséquent, la tension de substrat V_{BULK2} du transistor 216 est augmentée pour réduire le courant de fuite passant vers la masse par l'intermédiaire du transistor 216. La tension de substrat V_{BULK1} du transistor 214 reste toutefois faible, de sorte que le transistor 214 reste complètement conducteur.

Les figures 7A et 7B illustrent le circuit d'entrée 504 de la figure 5 plus en détail selon des exemples de réalisation.

La figure 7A illustre le cas où le circuit d'entrée 504 est un inverseur, comprenant un transistor PMOS 702 couplé par ses bornes de courant principales entre le noeud 506 et la tension d'alimentation V_{DD}, et un transistor NMOS 704 couplé par ses bornes de courant principales entre le noeud 506 et la masse. Ainsi, un état bas du signal de données D va provoquer le couplage du noeud 506 à la tension d'alimentation V_{DD} par l'intermédiaire du transistor 702.

La figure 7B illustre le cas où le circuit d'entrée 504 est une porte NON ET, comprenant des transistors PMOS 710 et 712 couplés en parallèle entre le noeud 506 et la tension d'alimentation V_{DD}, et des transistors NMOS 714, 716 couplés en série entre le noeud 506 et la masse. La donnée d'entrée D comprend deux signaux de données a et b. Les transistors 710 et 714 sont contrôlés par le signal de données a, et les transistors 712 et 716 sont contrôlés par le signal de données b. Ainsi, lorsque le signal a et/ou b est bas, le noeud 506 est couplé à la tension d'alimentation V_{DD} par l'intermédiaire du transistor 710 et/ou 712.

De façon plus générale, les blocs de circuit 508 et 510 du circuit d'entrée 504 sont par exemple agencés pour appliquer à la donnée d'entrée D au moins l'une des fonctions logiques du groupe comprenant : une fonction de multiplexage ; une fonction NON ; une fonction NON OU ; une fonction NON ET ; une fonction NON OU EXCLUSIF ; une fonction OU ; une fonction ET ; et une fonction OU EXCLUSIF.

La figure 8 illustre une cellule mémoire 800 selon une variante de réalisation par rapport à la figure 5. De nombreux éléments sont les mêmes que ceux de la figure 5, et ces éléments ne seront pas décrits en détail. La différence dans le circuit de la figure 8 est que les transistors NMOS sont remplacés par des PMOS, et vice-versa. En particulier, les transistors NMOS 214 et 216 ont été remplacés par des transistors PMOS 814 et 816. Le noeud 218 est connecté à la tension d'alimentation V_{DD}. En outre, les transistors PMOS 222 et 224 ont été remplacés par des transistors NMOS 822 et 824 couplés à la masse. Le transistor PMOS 230 a été remplacé par un transistor NMOS 830 couplé à la masse.

Il apparaîtra clairement à l'homme de l'art que le fonctionnement de la cellule mémoire de la figure 8 est sensiblement similaire à celui de la cellule mémoire de la figure 5, la seule différence étant les inversions normales de tension résultant de l'échange NMOS/PMOS. Pour faciliter l'illustration, un circuit de commande basé sur le circuit de commande 534 de la figure 5 n'est pas illustré en figure 8. En outre, bien que cela ne soit pas représenté en figure 8, les tensions de substrat de l'un des transistors 814, 816, qui sont par exemple normalement à la tension d'alimentation V_{DD}, pourraient être amenées à une valeur inférieure, par exemple à la masse, pendant une phase d'écriture, comme dans le procédé décrit précédemment en relation avec la figure 5.

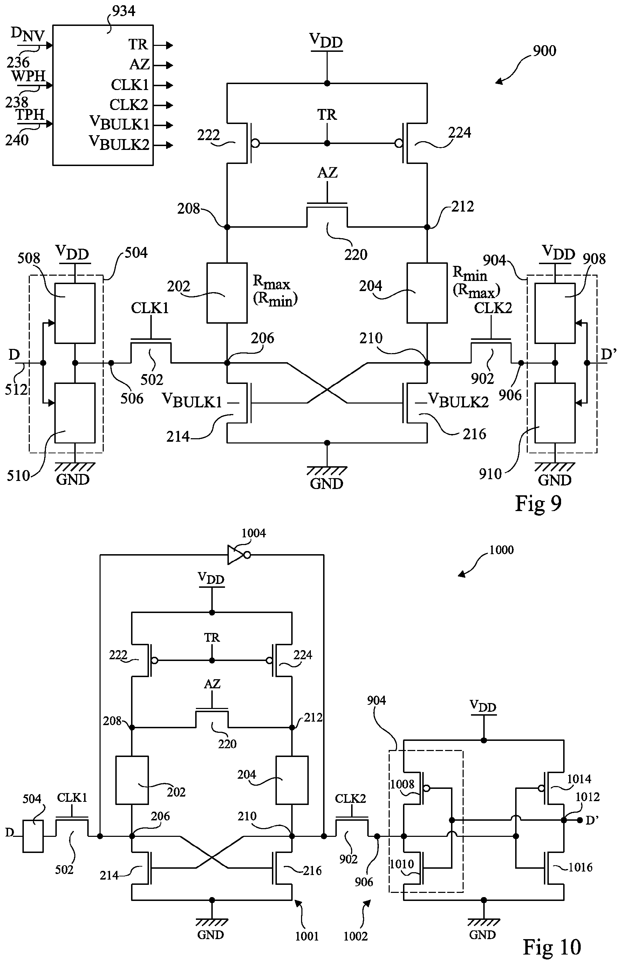

La figure 9 illustre une cellule mémoire 900 selon une variante de réalisation par rapport à la figure 5. De nombreux éléments sont les mêmes que ceux de la figure 5, et ces éléments ne seront pas décrits en détail. La différence dans le circuit de la figure 9 est que le transistor PMOS 230 n'est plus présent, et au lieu de cela, le noeud de mémorisation 210 est couplé par l'intermédiaire des noeuds de courant principaux d'un transistor NMOS 902 à un autre circuit d'entrée 904. En particulier, le transistor 902 est couplé à un noeud d'entrée de données 906 de la cellule mémoire 900. Le noeud 906 est couplé à la tension d'alimentation V_{DD} par l'intermédiaire d'un bloc de circuit 908 du circuit d'entrée 904, et à la masse par l'intermédiaire d'un bloc de circuit 910 du circuit d'entrée 904. Le transistor 502 en figure 9 est contrôlé par un signal d'horloge CLK1, et le transistor 902 est contrôlé par un signal d'horloge CLK2. Les blocs de circuit 908 et 910 sont contrôlés par une donnée d'entrée D'. Comme pour la donnée d'entrée D, la donnée d'entrée D' peut comprendre un seul signal de données ou plusieurs signaux de données.

Comme dans le circuit d'entrée 504, le circuit d'entrée 904 pourrait correspondre au circuit des figures 7A et 7B, ou de façon plus générale, à tout circuit logique qui est par exemple agencé pour appliquer à la donnée d'entrée D au moins l'une des fonctions logiques du groupe comprenant : une fonction de multiplexage ; une fonction NON ; une fonction NON OU ; une fonction NON ET ; une fonction NON OU EXCLUSIF ; une fonction OU ; une fonction ET ; et une fonction OU EXCLUSIF.

Le fonctionnement de la cellule mémoire 900 est similaire à celui de la figure 5, excepté que, afin de générer un courant d'écriture à partir du noeud de mémorisation 210, à travers les éléments résistifs 202 et 204, vers le noeud de mémorisation 206, le transistor 902 est activé et le noeud 906 est couplé à la tension d'alimentation V_{DD} par l'intermédiaire du bloc de circuit 908 par une valeur appropriée du signal de données D'.

Ainsi, en utilisant à la fois les transistors 502, 902 et les circuits d'entrée 504, 904 pour appliquer des tensions aux noeuds de mémorisation 206 et 210 pendant des phases d'écriture des éléments résistifs 202, 204, le reste de la cellule mémoire 900 peut être mis en oeuvre en utilisant seulement cinq transistors.

La figure 10 illustre un dispositif mémoire synchrone 1000 basé sur le circuit de la figure 9, selon un exemple de réalisation. Bien sûr, dans une variante de réalisation, le dispositif mémoire 1000 pourrait également être basé sur la cellule mémoire de la figure 5 ou celle de la figure 8. Le dispositif mémoire synchrone 1000 de la figure 10 est une bascule, et en particulier une bascule de type D. Cependant, il apparaîtra clairement à l'homme de l'art que d'autres types de dispositifs mémoires synchrones pourraient aussi être mis en oeuvre sur la base des mêmes principes.

Les noeuds de mémorisation 206, 210 et les transistors 214, 216 forment un registre maître 1001 du dispositif mémoire 1000, tandis que le circuit 904 fait partie d'un registre esclave 1002 du dispositif mémoire 1000, couplé en série avec le registre maître 1001 par l'intermédiaire du transistor 902. Le noeud de mémorisation 206 est en outre couplé au noeud de mémorisation 210 de la cellule mémoire 1001 par l'intermédiaire d'un inverseur 1004.

Le circuit 904 du registre esclave 1002 est un inverseur comprenant un transistor PMOS 1008 couplé entre le noeud 906 et la tension d'alimentation V_{DD}, et un transistor NMOS 1010 couplé entre le noeud 906 et la masse. Le registre esclave 1002 comprend un autre inverseur constitué d'un transistor PMOS 1014 et d'un transistor NMOS 1016 couplés en série entre V_{DD} et la masse. Les noeuds de commande des transistors 1014 et 1016 sont couplés au noeud 906, et les noeuds de commande des transistors 1008 et 1010 sont couplés à un noeud 1012 entre les transistors 1014 et 1016. Les transistors 1014 et 1016 fournissent la donnée d'entrée D' sur un noeud 1012, qui est par exemple un noeud de sortie du dispositif mémoire synchrone 1000.

En fonctionnement, quel que soient les états résistifs programmés des éléments résistifs 202 et 204, le dispositif mémoire synchrone 1000 peut opérer comme une bascule standard, mémorisant des données sur ses noeuds de mémorisation 206, 210 et 906, 1012 de façon volatile, sur la base de données d'entrée D présentées sur l'entrée du circuit 504. En particulier, sur un front montant de l'horloge CLK1, la sortie du circuit d'entrée 504 est mémorisée sur le noeud de mémorisation 206 et son inverse est mémorisé sur le noeud 210. Ensuite, sur un front montant du signal d'horloge CLK2, la donnée sur le noeud de mémorisation 210 est mémorisée sur le noeud de mémorisation 906, et son inverse est mémorisé sur le noeud de mémorisation 1012.

En outre, des données peuvent être mémorisées de façon non volatile en programmant les états résistifs des éléments mémoire 202 et 204, comme cela a été décrit précédemment. Ces données peuvent aussi être transférées vers les noeuds de mémorisation 206 et 210 en activant, pendant que les signaux d'horloge CLK1 et CLK2 sont bas, les transistors 222 et 224 pendant une phase de transfert comme cela a été décrit précédemment, et les données deviennent ensuite accessibles sur la sortie D' de la bascule 1000 après le front d'horloge montant suivant du signal d'horloge CLK2.

Pendant une phase d'écriture des éléments résistifs 202, 204, pour générer un courant à partir du noeud de mémorisation 206, à travers les éléments 202, 204, vers le noeud de mémorisation 210, le signal CLK1 est amené à l'état haut pour activer le transistor 502, et le noeud de mémorisation 206 est couplé à la tension d'alimentation V_{DD} par l'intermédiaire du circuit d'entrée 504.

Pendant une autre phase d'écriture, pour générer un courant à partir du noeud de mémorisation 210, à travers les éléments 202, 204, vers le noeud de mémorisation 206, le signal CLK1 est par exemple de nouveau amené à l'état haut pour activer le transistor 502, et le noeud de mémorisation 206 est couplé à la masse par l'intermédiaire du circuit d'entrée 504. L'inverseur 1004 va alors appliquer une tension relativement élevée au noeud de mémorisation 210. En outre, le signal d'horloge CLK2 peut être amené à l'état haut pour activer le transistor 902, et le noeud de mémorisation 210 couplé à la tension d'alimentation V_{DD} par l'intermédiaire du transistor 1008, sur la base d'un état bas du signal de données D'.

Il sera clair pour l'homme de l'art que dans des variantes de réalisation, les positions des registres 1001 et 1002 de la figure 10 pourraient être interverties, le circuit 1002 formant le registre maître et le circuit 1001 formant le registre esclave.

La figure 11 illustre un réseau mémoire 1100 comprenant un réseau de cellules mémoires 1102. Dans l'exemple de la figure 11, il y a neuf cellules mémoires 1102 agencées en trois rangées et trois colonnes. Cependant, il pourrait y avoir seulement deux rangées et/ou deux colonnes, ou, comme cela est représenté par des lignes en pointillés en figure 11, il pourrait y avoir plus que trois rangées et/ou plus que trois colonnes.

Chaque cellule mémoire 1102 par exemple correspond sensiblement à la cellule mémoire de la figure 9 décrite précédemment, dans laquelle les transistors 502 et 902 sont couplés à des lignes de bits correspondantes BL et B̅L̅ respectivement. En outre, ces deux transistors sont contrôlés par le même signal WL décrit plus en détail ci-après. En outre, le circuit de commande 934 de chaque cellule mémoire a été remplacé par des blocs de commande communs de rangées et de colonnes, comme on va le décrire maintenant.

Un bloc de commande de rangées 1104 fournit des signaux de commande sur des lignes de rangées 1105 vers les cellules mémoires, un groupe de lignes de rangées 1105 communes étant prévu pour chaque rangée. Par exemple, chaque groupe de lignes de rangées 1105 comprend un signal de ligne de mot WL pour contrôler les transistors 502, 902 de chaque cellule mémoire 1102. En outre, ce groupe de lignes de rangées 1105 comprend par exemple le signal AZ pour contrôler le transistor 220 de chaque cellule mémoire. Le bloc de commande de rangées 1104 fournit aussi par exemple le signal de transfert TR à chaque cellule mémoire sur une ligne de rangées 1106 correspondante, une ligne de rangées commune 1106 étant prévue pour les cellules mémoires de chaque rangée. Les signaux de transfert contrôlent les transistors 222, 224 de la cellule mémoire 200.

Un bloc de commande de colonnes 1108 par exemple reçoit des données D_{V} à mémoriser de façon volatile par une rangée de cellules mémoires pendant une opération d'écriture standard, et des données D_{NV} à mémoriser de façon non volatile par chacune des cellules mémoires pendant une phase d'écriture des éléments résistifs 202, 204 de chaque cellule mémoire 1102. Le bloc de commande de colonnes 1108 est couplé à chacune des lignes de bit BL et B̅L̅, et comprend, pour chaque paire de lignes de bit BL et B̅L̅, des circuits d'entrée communs 504, 904 pour chacune des cellules mémoires.

En fonctionnement, pendant une phase d'écriture des éléments résistifs 202, 204 dans chacune des cellules mémoires 1102, une seule rangée de cellules mémoires est programmée à la fois. La programmation est par exemple réalisée en activant le signal de lignes de mots WL et le signal AZ de chacune des cellules mémoires de la rangée à programmer, pour activer les transistors correspondant 220, 502 et 902. Cela crée un chemin de conduction entre les lignes de bit BL et B̅L̅ de chaque colonne, passant à travers les éléments résistifs 202, 204 de chaque cellule mémoire. La ligne de bit BL ou B̅L̅ de chaque colonne est ensuite couplée sélectivement à la tension d'alimentation V_{DD} pour générer le courant d'écriture dans une direction qui dépend de la donnée D_{NV} à programmer.

Pour mettre en oeuvre une phase de transfert telle que les données mémorisées par les éléments résistifs 202, 204 soient transférées vers les noeuds de mémorisation 206, 210, le signal de transfert TR et le signal AZ sont activés comme cela a été décrit en relation avec les figures 3A et 3B précédemment, et cette opération peut être réalisée sur chacune des cellules mémoires 1102 à la fois. Les données peuvent ensuite être lues dans chaque cellule mémoire rangée par rangée de façon standard.

En plus de la mémorisation de données de façon non volatile, des données peuvent être mémorisées de façon volatile dans chaque cellule mémoire de la même façon qu'avec une mémoire RAM.

Les figures 12A et 12B illustrent les structures d'éléments résistifs à couple de transfert de spin (STT) selon des exemples de réalisation. Par exemple, chacun des éléments résistifs 202 et/ou 204 décrits ici a une structure correspondant à celle de la figure 12A ou 12B. En variante, comme cela a été mentionné précédemment, les éléments résistifs pourraient être des éléments de mémoire RAM RedOx, des éléments FeRAM, des éléments PCRAM, ou d'autres types d'éléments résistifs ayant une résistance programmable par la direction d'un flux de courant.

La figure 12A illustre un élément résistif STT 1200 ayant une anisotropie magnétique dans le plan. L'élément 1200 est par exemple sensiblement cylindrique, mais a une section qui est non circulaire, par exemple ovale, ce qui conduit par exemple à une augmentation de la stabilité de rétention des états résistifs lorsque le dispositif est programmé.

L'élément 1200 comprend des électrodes inférieure et supérieure 1202 et 1204, chacune ayant sensiblement une forme de disque, et prenant en sandwich un certain nombre de couches intermédiaires entre elles. Les couches intermédiaires comprennent, du bas vers le haut, une couche fixe 1206, une barrière d'oxydation 1208, et une couche de mémorisation 1210.

La barrière d'oxydation 1208 est par exemple en MgO ou en AlₓO_{y}. La couche fixe 1206 et la couche de mémorisation 1210 sont par exemple en matériau ferromagnétique, comme du CoFe. La direction de spin dans la couche fixe 1206 est fixe, comme cela est représenté par une flèche allant de la gauche vers la droite en figure 12A. Bien sûr, dans des variantes de réalisation, la direction de spin pourrait être de la droite vers la gauche dans la couche fixe 1206. Cependant, la direction de spin dans la couche de mémorisation 1210 peut être changée, comme cela est représenté par des flèches ayant des directions opposées en figure 12A. La direction de spin est programmée par la direction du courant d'écriture I qu'on fait passer dans l'élément, de sorte que la direction de spin dans la couche de mémorisation est parallèle, en d'autres termes, dans la même direction, ou anti-parallèle, en d'autres termes dans la direction opposée, par rapport à la couche fixe 1206.

La figure 12B illustre un élément résistif STT 1220 ayant une anisotropie magnétique perpendiculaire au plan. Un tel élément résistif peut par exemple être programmé par un courant d'écriture I plus faible que pour l'élément 1200 pour une taille donnée et/ou pour un volume donné de couche de mémorisation. Un tel élément est par conséquent par exemple utilisé dans la cellule mémoire 500 de la figure 5, où un courant d'écriture relativement faible est souhaitable.

L'élément 1220 est sensiblement cylindrique, et a par exemple une section qui est circulaire. L'élément 1220 comprend des électrodes inférieure et supérieure 1222 et 1224, chacune ayant sensiblement une forme de disque et prenant en sandwich un certain nombre de couches intermédiaires. Les couches intermédiaires comprennent, du bas vers le haut, une couche fixe 1226, une barrière d'oxydation 1228, et une couche de mémorisation 1230. Ces couches sont similaires aux couches correspondantes 1206, 1208 et 1210 de l'élément 1200, excepté que la couche fixe 1226 et la couche de mémorisation 1230 ont une anisotropie perpendiculaire au plan, comme cela est représenté par les flèches verticales dans les couches 1226 et 1230 de la figure 12B. La couche fixe 1226 est illustrée comme ayant une direction de spin allant du bas vers le haut en figure 12B, mais bien sûr, dans des variantes de réalisation, cette direction de spin pourrait être du haut vers le bas.

Si l'élément STT 1200 ou 1220 de la figure 12A ou 12B est utilisé pour mettre en oeuvre chacun des éléments résistifs 202, 204 décrits ici, leurs orientations peuvent par exemple être choisies de façon à minimiser le niveau de courant d'écriture qui permet de les programmer. En particulier, en fonction de facteurs tels que les dimensions des éléments 202, 204, on peut avoir un faible courant d'écriture lorsque chaque élément a son électrode inférieure 1202, 1222 connectée au noeud de mémorisation 206, 210, correspondant, ou bien le contraire peut être vrai aussi.

Avec la description ainsi faite de plusieurs modes de réalisation illustratifs, diverses altérations, modifications et améliorations apparaîtront facilement à l'homme de l'art.

Par exemple, il sera clair pour l'homme de l'art que la tension d'alimentation V_{DD} dans les divers modes de réalisation pourrait avoir un niveau quelconque, par exemple entre 1 et 3 V, et plutôt que d'être à 0 V, la tension de masse peut aussi être considérée comme étant une tension d'alimentation qui pourrait être à un niveau quelconque, comme un niveau négatif.

En outre, il sera clair pour l'homme de l'art que, dans tous les modes de réalisation décrits ici, tous les transistors NMOS pourraient être remplacés par des transistors PMOS, et/ou tous les transistors PMOS pourraient être remplacés par des transistors NMOS. L'homme de l'art saura comment tous les circuits peuvent être mis en oeuvre en utilisant uniquement des transistors PMOS ou uniquement des transistors NMOS. En outre, bien qu'on ait décrit ici des transistors basés sur la technologie MOS, dans des variantes de réalisation on pourrait utiliser d'autres technologies de transistors, comme la technologie bipolaire.

## Revendications

1. Cellule mémoire comprenant :
des premier et deuxième éléments résistifs (202, 204), au moins l'un d'eux étant programmable pour prendre l'un d'au moins deux états résistifs (Rₘᵢₙ, Rₘₐₓ), une valeur de donnée étant représentée par les résistances relatives des premier et deuxième éléments résistifs, le premier élément résistif (202) étant couplé entre un premier noeud de mémorisation (206) et un premier noeud intermédiaire (208), le deuxième élément résistif (204) étant couplé entre un deuxième noeud de mémorisation (210) et un deuxième noeud intermédiaire (212) ;
un premier transistor (214) couplé entre le premier noeud de mémorisation et une première tension d'alimentation (GND, V_{DD});
un deuxième transistor (216) couplé entre le deuxième noeud de mémorisation et la première tension d'alimentation, un noeud de commande du premier transistor étant couplé au deuxième noeud de mémorisation et un noeud de commande du deuxième transistor étant couplé au premier noeud de mémorisation ;
un troisième transistor (220) couplé entre les premier et deuxième noeuds intermédiaires ;
**caractérisée par** un quatrième transistor (502) couplé par ses noeuds de courant principaux entre le premier noeud de mémorisation (206, 210) et un noeud d'entrée de données (506, 906) ; et
un circuit de commande (534, 934) agencé, pendant une phase d'écriture, pour activer les troisième et quatrième transistors et pour coupler le noeud d'entrée de données à une deuxième tension d'alimentation (V_{DD}, GND) par l'intermédiaire d'un premier bloc de circuit (508, 908) pour générer un courant de programmation dans une première direction à travers les premier et deuxième éléments résistifs pour programmer l'état résistif d'au moins l'un desdits éléments.

2. Cellule mémoire selon la revendication 1, dans laquelle le premier bloc de circuit (508, 908) comprend au moins un transistor couplé entre le noeud d'entrée de données et la deuxième tension d'alimentation et contrôlé par des données d'entrée (D, D') de la cellule mémoire.

3. Cellule mémoire selon la revendication 1 ou 2, comprenant en outre un deuxième bloc de circuit (510, 910) comprenant au moins un transistor couplé entre le noeud d'entrée de données et la première tension d'alimentation et contrôlé par les données d'entrée (D, D') de la cellule mémoire.

4. Cellule mémoire selon la revendication 3, dans lequel les premier et deuxième blocs de circuit sont agencés pour appliquer à la donnée d'entrée au moins l'une des fonctions logiques du groupe comprenant : une fonction de multiplexage ; une fonction NON ; une fonction NON OU ; une fonction NON ET ; une fonction NON OU EXCLUSIF ; une fonction OU ; une fonction ET ; et une fonction OU EXCLUSIF.

5. Cellule mémoire selon l'une quelconque des revendications 1 à 4, comprenant en outre un cinquième transistor (226, 230) couplé entre le deuxième noeud de mémorisation (206, 210) et la deuxième tension d'alimentation (V_{DD}, GND), dans laquelle le circuit de commande est en outre agencé, pendant une autre phase d'écriture, pour activer les troisième et cinquième transistors pour générer un courant de programmation dans une deuxième direction dans les premier et deuxième éléments résistifs pour programmer l'état résistif d'au moins l'un des éléments.

6. Cellule mémoire selon l'une quelconque des revendications 1 à 4, comprenant en outre un sixième transistor (902) couplé entre le deuxième noeud de mémorisation (206, 210) et un autre noeud d'entrée de données (506, 906), dans laquelle le circuit de commande (534, 934) est en outre agencé, pendant une autre phase d'écriture, pour activer les troisième et sixième transistors et pour coupler l'autre noeud d'entrée de données à la deuxième tension d'alimentation (V_{DD}, GND) par l'intermédiaire d'un autre bloc de circuit (508, 908) pour générer un courant de programmation dans une deuxième direction dans les premier et deuxième éléments résistifs pour programmer l'état résistif d'au moins l'un des éléments.

7. Cellule mémoire selon la revendication 3 ou 4, comprenant en outre un inverseur (1004) couplé entre le premier noeud de mémorisation et le deuxième noeud de mémorisation, dans laquelle le circuit de commande (534, 934) est en outre agencé, pendant une autre phase d'écriture, pour activer les troisième et quatrième transistors et pour coupler le noeud d'entrée de données à la première tension d'alimentation (V_{DD}, GND) par l'intermédiaire du deuxième bloc de circuit (508, 908) pour générer un courant de programmation dans une deuxième direction dans les premier et deuxième éléments résistifs pour programmer l'état résistif d'au moins l'un des éléments.

8. Cellule mémoire selon l'une quelconque des revendications 1 à 7, dans laquelle chacun des premier et deuxième transistors (214, 216) est connecté à la première tension d'alimentation.

9. Cellule mémoire selon l'une quelconque des revendications 1 à 8, dans laquelle au moins l'un des premier et deuxième éléments résistifs est l'un des éléments suivants :
un élément à couple de transfert de spin ayant une anisotropie dans le plan ;
un élément à couple de transfert de spin ayant une anisotropie perpendiculaire au plan ;
un élément à oxydoréduction (RedOx) ;
un élément ferroélectrique ; et
un élément à changement de phase.

10. Cellule mémoire selon l'une quelconque des revendications 1 à 9, dans laquelle chacun des premier et deuxième transistors comprend un noeud de substrat, et dans laquelle le circuit de commande est en outre agencé pour coupler le noeud de substrat d'au moins l'un des premier et deuxième transistors à une troisième tension d'alimentation différente de la première tension d'alimentation pendant que le noeud d'entrée de données est couplé à la deuxième tension d'alimentation (V_{DD}, GND) .

11. Cellule mémoire selon l'une quelconque des revendications 1 à 10, comprenant en outre :
un septième transistor (222) couplé entre le premier noeud intermédiaire et la deuxième tension d'alimentation ; et
un huitième transistor (224) couplé entre le deuxième noeud intermédiaire et la deuxième tension d'alimentation.

12. Cellule mémoire selon la revendication 11, dans laquelle les septième et huitième transistors sont adaptés à avoir une tension de seuil inférieure à celle des premier et deuxième transistors.

13. Dispositif mémoire comprenant :
un réseau de cellules mémoires, chaque cellule mémoire comprenant la cellule mémoire de l'une quelconque des revendications 1 à 12, dans lequel les noeuds d'entrée de données des cellules mémoires sont couplés à des premières lignes de bits (BL) du dispositif mémoire.

14. Dispositif mémoire synchrone comprenant :
la cellule mémoire de l'une quelconque des revendications 1 à 12 ; et
une autre cellule mémoire couplée en série avec la cellule mémoire, l'autre cellule mémoire comprenant deux inverseurs couplés de façon croisée.

15. Procédé de mémorisation non volatile d'une valeur de donnée dans une cellule mémoire, la cellule mémoire comprenant : des premier et deuxième éléments résistifs (202, 204), dont au moins l'un est programmable pour prendre l'un d'au moins deux états résistifs (Rₘᵢₙ, Rₘₐₓ), une valeur de donnée étant représentée par les résistances relatives des premier et deuxième éléments résistifs, le premier élément résistif (202) étant couplé entre un premier noeud de mémorisation (206) et un premier noeud intermédiaire (208), le deuxième élément résistif (204) étant couplé entre un deuxième noeud de mémorisation (210) et un deuxième noeud intermédiaire (212) ; un premier transistor (214) couplé entre le premier noeud de mémorisation et une première tension d'alimentation (GND, V_{DD}) ; un deuxième transistor (216) couplé entre le deuxième noeud de mémorisation et la première tension d'alimentation, un noeud de commande du premier transistor étant couplé au deuxième noeud de mémorisation et un noeud de commande du deuxième transistor étant couplé au premier noeud de mémorisation ; un troisième transistor (220) couplé entre les premier et deuxième noeuds intermédiaires ; **caractérisé par** un quatrième transistor (502) couplé par ses noeuds de courant principaux entre le premier noeud de mémorisation (206, 210) et un noeud d'entrée de données (506, 906), le procédé comprenant :
activer les troisième et quatrième transistors ;
coupler le noeud d'entrée de données à une deuxième tension d'alimentation (V_{DD}, GND) par l'intermédiaire d'un premier bloc de circuit d'entrée (508, 908) pendant que les troisième et quatrième transistors sont activés pour générer un courant de programmation dans une première direction dans les premier et deuxième éléments résistifs pour programmer l'état résistif d'au moins l'un des éléments.

## Patentansprüche

1. Speicherzelle, die Folgendes aufweist:
erste und zweite Widerstandselemente (202, 204), von denen wenigstens eines programmierbar ist, um einen von wenigstens zwei Widerstandszuständen (Rₘᵢₙ, Rₘₐₓ) zu haben, wobei ein Datenwert durch die relativen Widerstände der ersten und zweiten Widerstandselemente dargestellt wird, wobei das erste Widerstandselement (202) zwischen einem ersten Speicherknoten (206) und einem ersten Zwischenknoten (208) gekoppelt ist, wobei das zweite Widerstandselement (204) zwischen einem zweiten Speicherknoten (210) und einem zweiten Zwischenknoten (212) gekoppelt ist;
einen ersten Transistor (214), der zwischen dem ersten Speicherknoten und einer ersten Versorgungsspannung (GND, V_{DD}) gekoppelt ist;
einen zweiten Transistor (216), der zwischen dem zweiten Speicherknoten und der ersten Versorgungsspannung gekoppelt ist, wobei ein Steuerknoten des ersten Transistors mit dem zweiten Speicherknoten gekoppelt ist und ein Steuerknoten des zweiten Transistors mit dem ersten Speicherknoten gekoppelt ist;
einen dritten Transistor (220), der zwischen den ersten und zweiten Zwischenknoten gekoppelt ist; **gekennzeichnet durch**
einen vierten Transistor (502), der durch seine Hauptstromknoten zwischen dem ersten Speicherknoten (206, 210) und einem Dateneingangsknoten (506, 906) gekoppelt ist; und
Steuerschaltung (534, 934), die während einer Schreibphase konfiguriert ist, um die dritten und vierten Transistoren zu aktivieren und den Dateneingangsknoten über einen ersten Schaltungsblock (508, 908) mit einer zweiten Versorgungsspannung (V_{DD}, GND) zu koppeln, um einen Programmierstrom in einer ersten Richtung durch die ersten und zweiten Widerstandselemente zu erzeugen, um den Widerstandszustand von wenigstens einem der Elemente zu programmieren.

2. Speicherzelle nach Anspruch 1, wobei der erste Schaltungsblock (508, 908) wenigstens einen Transistor aufweist, der zwischen dem Dateneingangsknoten und der zweiten Versorgungsspannung gekoppelt und durch Eingangsdaten (D, D') der Speicherzelle gesteuert ist.

3. Die Speicherzelle nach Anspruch 1 oder 2, die ferner einen zweiten Schaltungsblock (510, 910) aufweist, der wenigstens einen Transistor aufweist, der zwischen dem Dateneingangsknoten und der ersten Versorgungsspannung gekoppelt und durch die Eingangsdaten (D, D') der Speicherzelle gesteuert ist.

4. Speicherzelle nach Anspruch 3, wobei die ersten und zweiten Schaltungsblöcke konfiguriert sind, um an die Eingangsdaten wenigstens eine der Gruppe von Logikfunktionen anzulegen, die Folgendes aufweist: eine Multiplexfunktion; eine NOT-Funktion; eine NOR-Funktion; eine NAND-Funktion; eine XNOR-Funktion; eine OR-Funktion; eine AND-Funktion; und eine XOR-Funktion.

5. Speicherzelle nach einem der Ansprüche 1 bis 4, die ferner einen fünften Transistor (226, 230) aufweist, der zwischen dem zweiten Speicherknoten (206, 210) und der zweiten Versorgungsspannung (V_{DD}, GND) gekoppelt ist, wobei die Steuerschaltung ferner konfiguriert ist, während einer weiteren Schreibphase die dritten und fünften Transistoren zu aktivieren, um einen Programmierstrom in einer zweiten Richtung durch das erste und zweite Widerstandselement zu erzeugen, um den Widerstandszustand von wenigstens einem der Elemente zu programmieren.

6. Speicherzelle nach einem der Ansprüche 1 bis 4, die ferner einen sechsten Transistor (902) aufweist, der zwischen dem zweiten Speicherknoten (206, 210) und einem weiteren Dateneingangsknoten (506, 906) gekoppelt ist, wobei die Steuerschaltung (534, 934) ferner konfiguriert ist, während einer weiteren Schreibphase die dritten und sechsten Transistoren zu aktivieren und den weiteren Dateneingangsknoten über einen weiteren Schaltungsblock (508, 908) mit der zweiten Versorgungsspannung (V_{DD}, GND) zu koppeln, um einen Programmierstrom in einer zweiten Richtung durch die ersten und zweiten Widerstandselemente zu erzeugen, um den Widerstandszustand von wenigstens einem der Elemente zu programmieren.

7. Speicherzelle nach Anspruch 3 oder 4, die ferner einen Inverter (1004) aufweist, der zwischen dem ersten Speicherknoten und dem zweiten Speicherknoten gekoppelt ist, wobei die Steuerschaltung (534, 934) ferner konfiguriert ist, während einer weiteren Schreibphase die dritten und vierten Transistoren zu aktivieren und den Dateneingangsknoten über den zweiten Schaltungsblock (508, 908) mit der ersten Versorgungsspannung (V_{DD}, GND) zu koppeln, um einen Programmierstrom in einer zweiten Richtung durch die ersten und zweiten Widerstandselemente zu erzeugen, um den Widerstandszustand von wenigstens einem der Elemente zu programmieren.

8. Die Speicherzelle nach einem der Ansprüche 1 bis 7, wobei jeder der ersten und zweiten Transistoren (214, 216) mit der ersten Versorgungsspannung verbunden ist.

9. Die Speicherzelle nach einem der Ansprüche 1 bis 8, wobei wenigstens eines der ersten und zweiten Widerstandselemente eines der Folgenden ist:
ein Spin-Transfer-Torque-Element mit In-Ebene-Anisotropie;
ein Spin-Transfer-Torque-Element mit senkrecht zur Ebene stehender Anisotropie;
ein Reduktionsoxid (RedOx)-Element;
ein ferroelektrisches Element; und
ein Phasenänderungselement.

10. Speicherzelle nach einem der Ansprüche 1 bis 9, wobei jeder der ersten und zweiten Transistoren einen Hauptknoten aufweist, und wobei die Steuerschaltung ferner konfiguriert ist, um den Hauptknoten von wenigstens einem der ersten und zweiten Transistoren mit einer dritten Versorgungsspannung zu koppeln, die sich von der ersten Versorgungsspannung unterscheidet, während der Dateneingangsknoten mit der zweiten Versorgungsspannung (V_{DD}, GND) gekoppelt ist.

11. Die Speicherzelle nach einem der Ansprüche 1 bis 10, die ferner Folgendes aufweist:
einen siebten Transistor (222), der zwischen dem ersten Zwischenknoten und der zweiten Versorgungsspannung gekoppelt ist; und
einen achten Transistor (224), der zwischen dem zweiten Zwischenknoten und der zweiten Versorgungsspannung gekoppelt ist.

12. Speicherzelle nach Anspruch 11, wobei die siebten und achten Transistoren geeignet sind, eine niedrigere Schwellenspannung als die ersten und zweiten Transistoren aufzuweisen.

13. Speichervorrichtung, die Folgendes aufweist:
eine Anordnung der Speicherzellen, wobei jede Speicherzelle die Speicherzelle nach einem der Ansprüche 1 bis 12 aufweist, wobei die Dateneingangsknoten der Speicherzellen mit ersten Bitleitungen (BL) der Speichervorrichtung gekoppelt sind.

14. Synchrone Speichervorrichtung, die Folgendes aufweist:
die Speicherzelle nach einem der Ansprüche 1 bis 12; und
eine weitere Speicherzelle, die in Reihe mit der Speicherzelle gekoppelt ist, wobei die weitere Speicherzelle ein Paar über Kreuz gekoppelter Inverter aufweist.

15. Verfahren zum nichtflüchtigen Speichern eines Datenwertes in einer Speicherzelle, wobei die Speicherzelle Folgendes aufweist: erste und zweite Widerstandselemente (202, 204), von denen wenigstens eines programmierbar ist, um einen von wenigstens zwei Widerstandszuständen (Rₘᵢₙ, Rₘₐₓ) zu haben, wobei ein Datenwert durch die relativen Widerstände der ersten und zweiten Widerstandselemente dargestellt wird, wobei das erste Widerstandselement (202) zwischen einem ersten Speicherknoten (206) und einem ersten Zwischenknoten (208) gekoppelt ist, wobei das zweite Widerstandselement (204) zwischen einem zweiten Speicherknoten (210) und einem zweiten Zwischenknoten (212) gekoppelt ist; einen ersten Transistor (214), der zwischen dem ersten Speicherknoten und einer ersten Versorgungsspannung (GND, V_{DD}) gekoppelt ist; einen zweiten Transistor (216), der zwischen dem zweiten Speicherknoten und der ersten Versorgungsspannung gekoppelt ist, wobei ein Steuerknoten des ersten Transistors mit dem zweiten Speicherknoten gekoppelt ist und ein Steuerknoten des zweiten Transistors mit dem ersten Speicherknoten gekoppelt ist; einen dritten Transistor (220), der zwischen den ersten und zweiten Zwischenknoten gekoppelt ist; **gekennzeichnet durch**
einen vierten Transistor (502), der durch seine Hauptstromknoten zwischen dem ersten Speicherknoten (206, 210) und einem Dateneingangsknoten (506, 906) gekoppelt ist, wobei das Verfahren Folgendes aufweist:
Aktivieren des dritten und vierten Transistors;
Koppeln des Dateneingangsknotens mit einer zweiten Versorgungsspannung (V_{DD}, GND) über einen ersten Eingangsschaltungsblock (508, 908), während die dritten und vierten Transistoren aktiviert werden, um einen Programmierstrom in einer ersten Richtung durch die ersten und zweiten Widerstandselemente zu erzeugen, um den Widerstandszustand von wenigstens einem der Elemente zu programmieren.

## Claims

1. A memory cell comprising:
first and second resistive elements (202, 204), at least one of which is programmable to have one of at least two resistive states (Rₘᵢₙ, Rₘₐₓ), a data value being represented by the relative resistances of the first and second resistive elements, the first resistive element (202) being coupled between a first storage node (206) and a first intermediate node (208), the second resistive element (204) being coupled between a second storage node (210) and a second intermediate node (212);
a first transistor (214) coupled between said first storage node and a first supply voltage (GND, V_{DD});
a second transistor (216) coupled between said second storage node and said first supply voltage, wherein a control node of said first transistor is coupled to said second storage node and a control node of said second transistor is coupled to said first storage node;
a third transistor (220) coupled between the first and second intermediate nodes; **characterized by**
a fourth transistor (502) coupled by its main current nodes between said first storage node (206, 210) and a data input node (506, 906); and
control circuitry (534, 934) configured, during a write phase, to activate said third and fourth transistors and to couple said data input node to a second supply voltage (V_{DD}, GND) via a first circuit block (508, 908) to generate a programming current in a first direction through said first and second resistive elements to program the resistive state of at least one of said elements.

2. The memory cell of claim 1, wherein said first circuit block (508, 908) comprises at least one transistor coupled between said data input node and said second supply voltage and controlled by input data (D, D') of said memory cell.

3. The memory cell of claim 1 or 2, further comprising a second circuit block (510, 910) comprising at least one transistor coupled between said data input node and said first supply voltage and controlled by said input data (D, D') of said memory cell.

4. The memory cell of claim 3, wherein said first and second circuit blocks are configured to apply to said input data at least one of the group of logic functions comprising: a multiplexing function; a NOT function; a NOR function; a NAND function; an XNOR function; an OR function; an AND function; and an XOR function.

5. The memory cell of any of claims 1 to 4, further comprising a fifth transistor (226, 230) coupled between said second storage node (206, 210) and said second supply voltage (V_{DD}, GND), wherein said control circuitry is further configured, during a further write phase, to activate said third and fifth transistors to generate a programming current in a second direction through said first and second resistive elements to program the resistive state of at least one said elements.

6. The memory cell of any of claims 1 to 4, further comprising a sixth transistor (902) coupled between said second storage node (206, 210) and a further data input node (506, 906), wherein said control circuitry (534, 934) is further configured, during a further write phase, to activate said third and sixth transistors and to couple said further data input node to said second supply voltage (V_{DD}, GND) via a further circuit block (508, 908) to generate a programming current in a second direction through said first and second resistive elements to program the resistive state of at least one of said elements.

7. The memory cell of claim 3 or 4, further comprising an inverter (1004) coupled between said first storage node and said second storage node, wherein said control circuitry (534, 934) is further configured, during a further write phase, to activate said third and fourth transistors and to couple said data input node to said first supply voltage (V_{DD}, GND) via said second circuit block (508, 908) to generate a programming current in a second direction through said first and second resistive elements to program the resistive state of at least one of said elements.

8. The memory cell of any of claims 1 to 7, wherein each of said first and second transistors (214, 216) is connected to said first supply voltage.

9. The memory cell of any of claims 1 to 8, wherein at least one of said first and second resistive elements is one of:
a spin transfer torque element with in-plane anisotropy;
a spin transfer torque element with perpendicular-to-plane anisotropy;
a reduction oxide (RedOx) element;
a ferro-electric element; and
a phase change element.

10. The memory cell of any of claims 1 to 9, wherein each of said first and second transistors comprises a bulk node, and wherein said control circuitry is further configured to couple the bulk node of at least one of said first and second transistors to a third supply voltage different from said first supply voltage while said data input node is coupled to said second supply voltage (V_{DD}, GND).

11. The memory cell of any of claims 1 to 10, further comprising:
a seventh transistor (222) coupled between said first intermediate node and said second supply voltage; and
an eighth transistor (224) coupled between said second intermediate node and said second supply voltage.

12. The memory cell of claim 11, wherein said seventh and eighth transistors are adapted to have a lower threshold voltage than said first and second transistors.

13. A memory device comprising:
an array of the memory cells, each memory cell comprising the memory cell of any of claims 1 to 12, wherein said data input nodes of said memory cells are coupled to first bit lines (BL) of said memory device.

14. A synchronous memory device comprising:
the memory cell of any of claims 1 to 12; and
a further memory cell coupled in series with said memory cell, the further memory cell comprising a pair of crosscoupled inverters.

15. A method of non-volatile storage of a data value in a memory cell, the memory cell comprising: first and second resistive elements (202, 204), at least one of which is programmable to have one of at least two resistive states (Rₘᵢₙ, Rₘₐₓ), a data value being represented by the relative resistances of the first and second resistive elements, the first resistive element (202) being coupled between a first storage node (206) and a first intermediate node (208), the second resistive element (204) being coupled between a second storage node (210) and a second intermediate node (212); a first transistor (214) coupled between said first storage node and a first supply voltage (GND, V_{DD}); a second transistor (216) coupled between said second storage node and said first supply voltage, wherein a control node of said first transistor is coupled to said second storage node and a control node of said second transistor is coupled to said first storage node; a third transistor (220) coupled between the first and second intermediate nodes; **characterized by**
a fourth transistor (502) coupled by its main current nodes between said first storage node (206, 210) and a data input node (506, 906), the method comprising:
activating said third and fourth transistors;
coupling said data input node to a second supply voltage (V_{DD}, GND) via a first input circuit block (508, 908) while said third and fourth transistors are activated to generate a programming current in a first direction through said first and second resistive elements to program the resistive state of at least one of said elements.
